Europäisches Patentamt

European Patent Office

Office européen des brevets

(11) Numéro de publication: **0 203 645 B1**

## (12) FASCICULE DE BREVET EUROPEEN

(45) Date de publication de fascicule du brevet:
28.08.91

(21) Numéro de dépôt: 86200784.6

(22) Date de dépôt: 05.05.86

(51) Int. Cl.⁵: **H03M 1/08, H03M 1/74**

(54) Circuit intégré de conversion numérique-analogique N/A muni d'un dispositif de réduction des pics de commutation.

(30) Priorité: 14.05.85 FR 8507282

(43) Date de publication de la demande:
03.12.86 Bulletin 86/49

(45) Mention de la délivrance du brevet:
28.08.91 Bulletin 91/35

(84) Etats contractants désignés:
DE FR GB

(56) Documents cités:
EP-A- 0 084 847
US-A- 3 614 776
US-A- 4 295 063

(73) Titulaire: **LABORATOIRES D'ELECTRONIQUE PHILIPS**
**3, Avenue Descartes**
**F-94450 Limeil-Brévannes(FR)**

(84) Etats contractants désignés:
**FR**

Titulaire: **N.V. Philips' Gloeilampenfabrieken**
**Groenewoudseweg 1**
**NL-5621 BA Eindhoven(NL)**

(84) Etats contractants désignés:
**DE GB**

(72) Inventeur: **Michel, Jean-Pierre**
**Société Civile S.P.I.D. 209, rue de l'Université**
**F-75007 Paris(FR)**

(74) Mandataire: **Landousy, Christian et al**
**Société Civile S.P.I.D. 156, Boulevard Haussmann**
**F-75008 Paris(FR)**

EP 0 203 645 B1

## Description

L'invention concerne un circuit intégré de conversion numérique-analogique N/A, muni d'un dispositif de réduction des pics de commutation, convertissant des signaux de commande à n états binaires Bn en signaux analogiques, comprenant n paires différentielles Pn de transistors T1n et T2n reliés à n générateurs de courant qui délivrent des courants de valeurs In pondérées selon les poids binaires $2^n$ des états binaires Bn, les transistors T1n étant réunis à leurs signaux binaires de commande respectifs et les transistors T2n étant respectivement réunis aux signaux binaires de commande inverses des précédents.

Elle concerne également les applications utilisant un tel circuit intégré de conversion notamment le traitement d'images.

Un circuit de ce type est décrit dans la publication intitulée : "Circuit Technique for Ultra Fast D/A Converters de W. LUSCHNIG et R. PETSCHACHER, ESSCIRC'83 9th European Solid State Cir. Conf. LAUSANNE Sep. 21-23 (1983).

Il y est décrit un convertisseur numérique-analogique rapide comportant un dispositif de réduction des pics de commutation (en anglais "glitch"). Un signal numérique, destiné à être transformé en un signal analogique, se présente généralement sous la forme d'un mot de n états binaires. Chaque état binaire Bn va ainsi posséder un poids binaire $2^n$. Une manière d'assurer la conversion numérique-analogique est donc d'effectuer la somme de courants dont les valeurs In sont pondérées selon le poids binaire $2^n$ de l'élément binaire Bn qui les contrôle.

Pour assurer une conversion numérique-analogique rapide le circuit décrit par ces auteurs comprend des paires différentielles. Mais lorsque les configurations des mots binaires successifs sont très différentes, avant d'obtenir un signal stable, il apparaît des variations rapides de la sortie liées à la commutation des transistors. Ainsi avec un mot binaire composé de 8 éléments binaires ce phénomène est à son maximum lorsque deux mots binaires qui se succèdent présentent les configurations 01111111 puis 10000000 ou l'inverse. Pour cette transition les sept sources de courant des états binaires de poids faibles doivent toutes commuter simultanément à l'opposé de la source de courant de poids fort. Dans un circuit de conversion numérique-analogique intégré, les techniques d'intégration conduisent à un bon regroupement des caractéristiques des éléments constitutifs du circuit intégré, en particulier les transistors. Ceux-ci ont donc des caractéristiques très voisines et vont commuter sous des conditions très voisines. Il s'ensuit que lors de transitions illustrées par les deux configurations précédentes, le signal analogique de sortie va présenter des anomalies de transition appelées pics de commutation (ou "glitches" en anglais) qui vont se caractériser par la grandeur de ce pic et par sa durée, donc son énergie.

L'énergie des pics de commutation est un paramètre important d'un circuit de conversion numérique-analogique et ceci d'autant plus que le circuit de conversion est rapide, donc pour lequel le niveau du signal analogique de sortie doit être rapidement stabilisé.

La solution décrite par W. LUSCHING et R. PETSCHACHER consiste à créer une dissymétrie de fonctionnement entre les deux transistors de chaque paire différentielle actionnée par chaque élément binaire Bn. En effet, par l'application sur la base de l'un des transistors de cette paire différentielle d'un signal de polarisation ajustable, on provoque un délai ajustable qui dépend du sens de variation du signal de commande appliqué sur la base de l'autre transistor de la paire différentielle.

Mais ceci présente des inconvénients car tout d'abord ce signal externe de polarisation nécessite une connexion vers une broche du circuit et un circuit propre à réaliser cette polarisation. Or disposer d'une broche n'est pas toujours possible sur des circuits intégrés performants où les broches sont réservées aux fonctions essentielles et indispensables.

D'autre part, ce circuit de polarisation doit être adapté aux variations de températures de l'environnement dans lequel opère le circuit de conversion numérique-analogique et ceci doit nécessiter des réglages et des moyens appropriés compte-tenu du mode externe de polarisation choisi.

Le but de l'invention est donc de diminuer l'énergie des pics de commutation d'un circuit de conversion numérique-analogique N/A en ne faisant pas appel à des réglages et des moyens externes au circuit et en adoptant des moyens peu sensibles aux conditions de température dans lesquelles évolue le circuit de conversion N/A.

Pour cela, l'invention telle que définie dans le préambule est remarquable en ce que l'instant de basculement des paires différentielles, sur un front montant du signal de commande, est décalé de l'instant de basculement sur un front descendant du signal de commande, en effectuant un décalage des seuils de basculement des transistors T1n par rapport aux transistors T2n, d'une valeur constante Vd, obtenue par le dispositif de réduction des pics de commutation constitué de résistances Rn, respectivement mises en série avec les émetteurs des transistors de l'une des séries de transistors T1n ou T2n de telle sorte que $Rn \cdot \frac{In}{2} = Vd$.

2

Supposons qu'une paire différentielle symétrique P1 reçoit un signal binaire 01 à l'état logique 1 et que la paire différentielle symétrique P2 reçoit un signal binaire B2 à l'état logique O. Pour la paire P1 c'est par exemple le transistor T11 qui est conducteur et le transistor T21 qui est bloqué. Pour la paire P2 l'ordre des transistors est inversé : le transistor T12 est bloqué et le transistor T22 est conducteur. Lorsque la configuration (B1 = 1, B2 = 0) passe à la configuration (B1 =0, B2 = 1), les transitions suivantes se présentent :

T11 passe à l'état bloqué

T21 passe à l'état conducteur

T12 passe à l'état conducteur

T22 passe à l'état bloqué.

Or, les paires différentielles sont conçues pour être symétriques dans la géométrie des transistors afin que les paramètres caractérisant le fonctionnement de chacun des transistors constituant cette paire soient très proches, leurs dispersions étant liées au procédé de fabrication. Mais le comportement dynamique d'une telle paire différentille ne sera pas symétrique selon le sens de variation du signal de commande. En effet, si l'on observe la variation du courant dans le collecteur d'un transistor, on constate que le délai qui s'écoule entre le signal de commande et la variation de ce courant, ainsi que la vitesse à laquelle ce courant évolue, ne sont pas identiques selon qu'il passe d'un état bloqué à un état conducteur et inversement.

Un des moyens pour réduire cet effet consiste à décaler le seuil de basculement des différentes paires entre une transition d'un état bloqué vers un état conducteur vis-à-vis d'une transition d'un état conducteur vers un état bloqué.

Pour cela l'invention décale les seuils de tous les transistors T1n ou de tous les transistors T2n d'une valeur sensiblement égale Vd. Ainsi lorsque le signal logique Bn présente une transition $1 \rightarrow 0$ ou $0 \rightarrow 1$ des décalages temporels vont apparaître pour les deux types de transitions.

Chaque paire différentielle est réunie à une source de courant de valeur In qui dépend du poids binaire de l'élément binaire auquel elle est connectée. On a :

$$In = i \cdot 2^n.$$

Pour assurer le décalage Vd, le dispositif de réduction des pics de commutation est constitué de n résistances Rn chacune étant respectivement mise en série avec les n émetteurs des transistors de l'une des séries de transistors T1n ou T2n. Les résistances Rn constituent une série dont les valeurs sons déterminées par :

$$Rn \cdot \frac{In}{2} = Vd \qquad soit \qquad Rn = \frac{2 \cdot Vd}{i \cdot 2^n}.$$

La valeur du courant élémentaire i se détermine en fonction des possibilités technologiques et des spécifications propres à l'application. La valeur de décalage Vd dépend de la technologie d'intégration utilisée et de la vitesse de fonctionnement prévue pour le convertisseur N/A. Si la valeur de Vd est grande les pics de commutation sont réduits mais le temps d'établissement du signal de sortie augmente, ce qui peut affecter la vitesse de fonctionnement du circuit de conversion.

Ce dispositif de réduction des pics de commutation reste très efficace si le signal de commande varie avec la température ou avec la tension d'alimentation.

L'invention sera mieux comprise à l'aide des dessins, donnés à titre d'exemple, qui représentent :

Figure 1 : un schéma électrique d'une paire différentielle classique.

Figure 2 : un diagramme représentant schématiquement, en fonction du temps, l'établissement des tensions de commande et des courants pour deux paires différentielles identiques illustrant l'apparition des pics de commutation.

Figure 3 : un diagramme montrant l'allure des pics de commutation observés sur un circuit de conversion numérique-analogique.

Figure 4 : un schéma électrique de deux paires différentielles munies du dispositif de réduction des pics de commutation selon l'invention.

Figure 5 : un diagramme indiquant, en fonction du temps, le déplacement de l'instant de basculement de deux paires différentielles Pn et Pn + 1 lorsque les transistors T1n et T1(n + 1) sont commandés l'un par un front montant et l'autre par un front descendant.

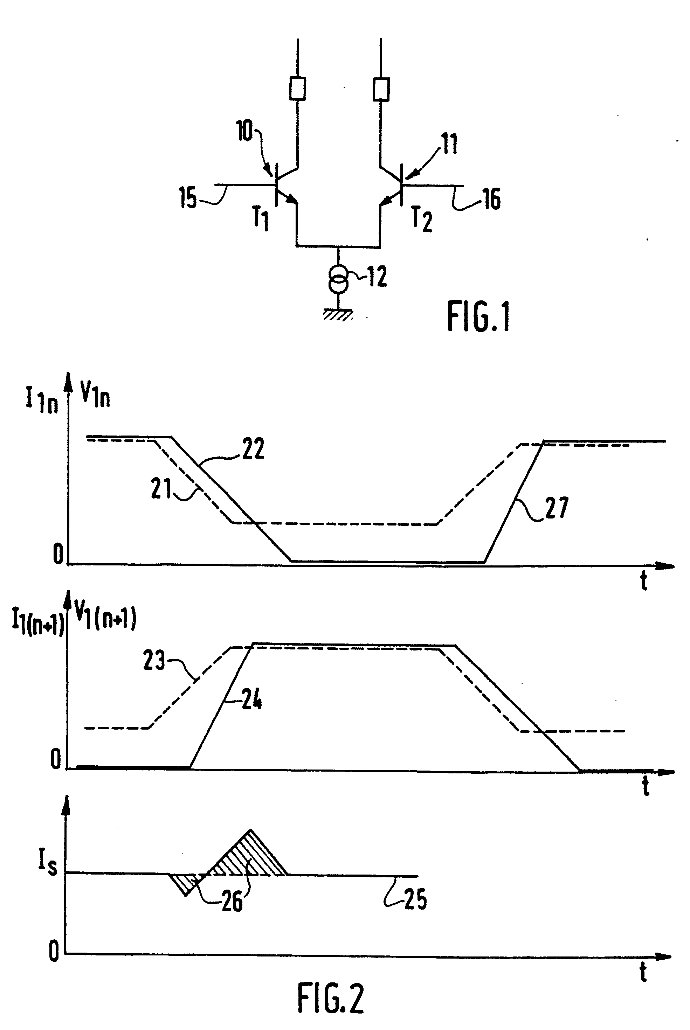

La figure 1 montre le schéma électrique d'une paire différentielle classique, pour laquelle les deux transistors T1, T2 sont réunis par leur émetteur à une même source de courant 12, et sont connectés, à un potentiel commum, chacun par leur collecteur à travers une résistance de charge. Les deux transistors T1, T2 sont commandés sur leur base 15, 16 par des tensions V1 et V2.

Le mécanisme d'apparition des pics de commutation est illustré par la figure 2. Soient deux paires différentielles, Pn, Pn + 1 telles que celle de la figure 1, ayant des caractéristiques identiques. Pour chaque paire, les signaux de commande des bases de T1n et de T2n d'une part et T1(n + 1) et T2(n + 1) d'autre part sont inversés.

Supposons qu'à un instant donné, la tension de commande de la base de T1n soit V1n et celle de la base de T1(n + 1) soit V1(n + 1) telles que représentées par les courbes 21 et 23 de la figure 2. Lorsque V1n passe d'un niveau haut à un niveau bas le courant I1n dans le collecteur de T1n représenté par la courbe 22 est en retard sur la tension de commande. Ce retard est dû aux différents éléments parasites liés au transistor et à la technologie utilisée : capacités parasites, résistances séries .... Le courant I1n décroît jusqu'à une valeur nulle (transistor T1n bloqué). Lorsque la tension de commande V1n croît à nouveau d'un niveau bas vers un niveau haut, le courant I1n se rétablit (transistor T1n conducteur) mais les éléments parasites n'interviennent pas de la même manière et le retard du courant I1n sur la tension de commande V1n et son temps de rétablissement sont différents du cas précédent (courbe 27).

Supposons que simultanément la paire différentielle Pn + 1 reçoit un signal de commande V1(n + 1) inversé par rapport à V1n représenté par la courbe 23. Le comportement des mécanismes de retard décrits pour T1(n + 1) sont identiques à ceux décrits pour T1n. L'allure du courant I1(n + 1) est représenté par la courbe 24. Pour représenter ce qui se passe dans un circuit de conversion numérique-analogique à sommation de courants, il faut considérer la somme des courants I1(n) et II(n + 1) représentée par la courbe 25. Le comportement dynamique dissymétrique des paires différentielles crée l'apparition du pic de commutation représenté par la zone hachurée 26 de la figure 2.

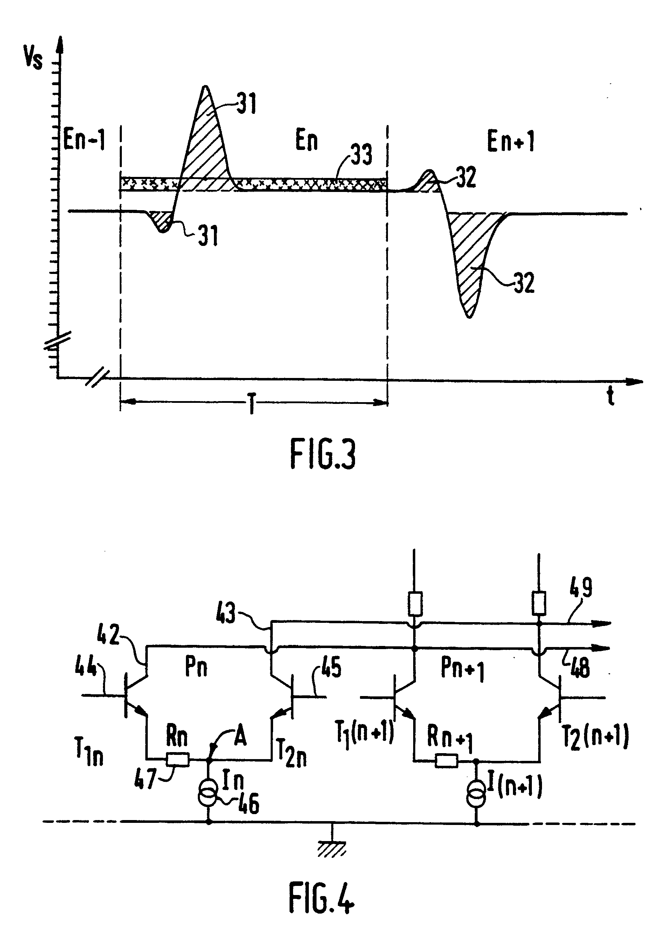

La figure 3 représente l'allure réelle des pics de commutation d'un circuit de conversion numérique-analogique qui effectue la sommation de courants issus de sources de courant pondérés selon une échelle en $2^n$. L'échantillon $E_{n-1}$ est par exemple l'échantillon 01111111 et l'échantillon En est l'échantillon 10000000. Dans cet exemple, il y a n = 8 paires différentielles. La figure 3 représente la tension de sortie Vs du circuit de conversion N/A en fonction du temps, sur laquelle une période d'échantillonnage T est isolée. Lorsque l'échantillon En est appliqué le pic de commutation 31 apparaît avec un certain retard. La zone est repérée par des hachures. Ce pic de commutation 31 est caractérisé par sa durée et la valeur maximale de son amplitude, c'est-à-dire par son énergie. Le pic de commutation étant en réalité constitué d'une partie négative et d'une partie positive, l'énergie du pic de commutation correspond à la différence des énergies relatives à chacun de ces pics. L'échelle de la tension de sortie Vs de la figure 3 représente des pas élémentaires égaux à l'excursion du signal de sortie produite par le changement du seul élément binaire le moins significatif (LSB en anglais) du mot à convertir. L'énergie du pic de commutation s'exprime généralement par le produit d'une durée multipliée par la valeur maximale de l'amplitude du pic exprimée en LSB.

Selon la vitesse - donc la durée T - à laquelle opère le circuit de conversion N/A dans une application donnée, cette énergie va être ou non très critique. Cette énergie caractérisant une imprécision, donc une erreur, sera d'autant plus gênante que la période T sera courte donc que le circuit de conversion N/A opérera rapidement. En ramenant cette énergie à une valeur moyenne répartie sur toute la durée T, le pic de commutation 31 se ramène à la zone 33 repérée par des croix. Sa hauteur caractérise l'erreur sur la précision du convertisseur N/A relative à ce phénomène et pour la période d'échantillonnage T. Plus la durée T est courte, plus la hauteur de la zone 33 s'élève et plus le convertisseur présente une erreur importante pouvant le rendre impropre à une application requérant une vitesse de fonctionnement élevée. La figure 3 montre également un autre pic de commutation 32, généré par un mécanisme semblable au précédent, dû au passage de l'échantillon En 10000000 à l'échantillon En + 1 01111111.

L'invention permet de réduire l'énergie de ces pics de commutation à l'aide d'un dispositif de réduction représenté sur la figure 4.

Pour analyser le mécanisme de fonctionnement, on définit le point de basculement d'une paire différentielle Pn de transistors T1n et T2n lorsque les courants sont égaux dans les deux collecteurs 42, 43 soit In/2. Dans ce cas, la tension base-émetteur des transistors au silicium T1n et T2n est voisine de 750 mV. Les tensions de commande appliquées sur les deux bases varient par exemple d'un niveau maximal $V_{max}$ = 2 volts à un niveau minimal $V_{min}$ = 1,5 volt. Pour que les courants I1n et I2n soient égaux, il faut appliquer sur la base 45 du transistor T2n une tension égale à $V_A + V_{BE}$, alors que la tension à appliquer sur la base 44 du transistor T1n est égale à $V_A + V_{BE} + Rn.\frac{In}{2}$, où $Rn.\frac{In}{2}$ représente la chute de tension Vd dans la résistance Rn 47 de la paire différentielle Pn. Cette tension Vd est choisie à une valeur déterminée en fonction de la technologie choisie. Pour une technologie bipolaire rapide à isolement par diffusion Vd est compris entre sensiblement 10 mV et sensiblement 70 mV, par exemple Vd = 30 mV. Les courants In étant, dans le cas du circuit de conversion N/A décrit, pondérées selon les poids binaires $2^n$, les résistances Rn doivent être choisies pour chaque paire différentielle de telle sorte que : $Rn . \frac{In}{2} = Vd$. Le signal de sortie du circuit de conversion N/A est prélevé sur les sorties 48, 49 qui réunissent respectivement tous les collecteurs des transistors T1n, T1(n+1)... entre eux, et tous les collecteurs des transistors T2n, T2(n+1)... entre eux.

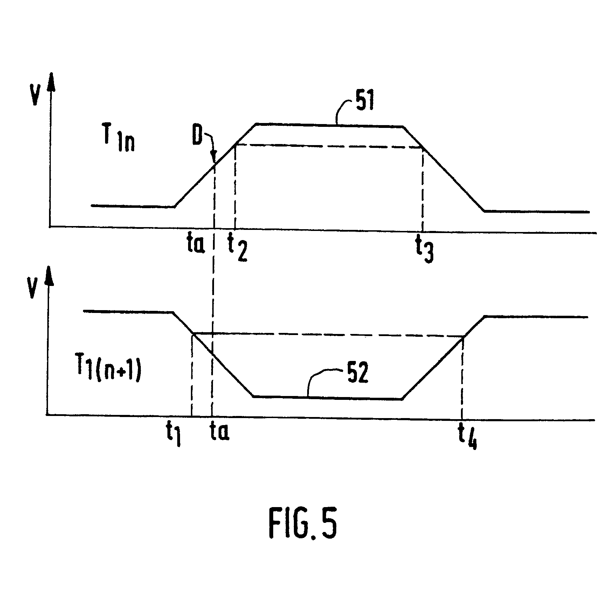

Pour que les courants soient égaux dans les deux collecteurs 42, 43, la tension de commande à appliquer sur la base 44 de T1n est supérieure de la valeur Vd à la tension à appliquer sur la base 45 de T2n. En conséquence par rapport à la situation d'une paire différentielle symétrique, le transistor T1n basculera plus tôt pour un front descendant de la tension de commande, mais basculera plus tardivement pour un front montant. Ceci est illustré par le diagramme de la figure 5 où sont représentés, en fonction du temps, les signaux de commande 51, 52 des transistors T1n et T1(n+1) des paires différentielles Pn et P-(n+1). Ces signaux de commande sont présentés inversées pour traiter la situation la plus significative. Le point D qui apparaît au temps ta représente l'instant de basculement d'une paire différentielle symétrique.

Mais pour des paires différentielles munies du dispositif de réduction des pics de commutation selon l'invention, l'instant de basculement de la paire différentielle va être décalé selon que le front est montant ou descendant. Le niveau de tension de commande provoquant le basculement étant plus élevé pour les transistors munis de leurs résistances d'émetteur, chaque transistor basculera plus tôt pour un front descendant et plus tard pour un front montant.

On observe ainsi le séquencement suivant:

T1(n+1)  bascule au temps t1 sur un front descendant
T1n   bascule au temps t2 sur un front montant
T1n   bascule au temps t3 sur un front descentant
T1(n+1)  bascule au temps t4 sur un front montant.

Le retard entre t1 et t2, lié à l'existence du seuil Vd créé par les résistances Rn, Rn+1 de chaque paire, permet de compenser les retards qui apparaissent dans une paire différentielle symétrique.

Bien évidemment chaque paire différentielle Pn participe à l'énergie des pics de commutation selon le poids binaire de l'élément binaire auquel elle se rapporte. Selon la précision recherché il peut être possible de négliger d'effectuer la correction de retard pour une ou plusieurs des paires de poids binaire les plus faibles.

Avec un circuit de conversion numérique-analogique muni d'un dispositif de réduction de pics de commutation, réalisé selon une technologie bipolaire rapide à isolement par diffusion, opérant sur des mots de 8 éléments binaires, la valeur maximale de l'énergie des pics de commutation a été de l'ordre de 40ns.LSB pour la configuration binaire des échantillons d'entrée la plus défavorable.

Cette énergie, si elle est intégrée sur la durée de la période d'échantillonnage, comme peut le faire l'oeil humain dans le cas des applications de traitement d'images, aura le même effet qu'une erreur de linéarité de

$$\frac{40ns.LSB}{T},$$

c'est-à-dire, dans le cas d'une période d'échantillonnage de 40ns, à une erreur équivalente de ± 1 LSB.

## Revendications

1.  Circuit intégré de conversion numérique-analogique N/A, muni d'un dispositif de réduction des pics de commutation, convertissant des signaux de commande à n états binaires Bn en signaux analogiques, comprenant n paires différentielles Pn de transistors T1n et T2n reliés à n générateurs de courant qui délivrent des courants de valeurs In pondérées selon les poids binaires $2^n$ des états binaires Bn, les transistors T1n étant réunis à leurs signaux binaires de commande respectifs et les transistors T2n étant respectivement réunis aux signaux binaires de commande inverses des précédents, caractérisé en ce que, l'instant de basculement des paires différentielles, sur un front montant du signal de commande, est décalé de l'instant de basculement sur un front descendant du signal de commande, en effectuant un décalage des seuils de basculement des transistors T1n par rapport aux transistors T2n, d'une valeur constante Vd, obtenue par le dispositif de réduction des pics de commutation constitué de résistances Rn, respectivement mises en série avec les émetteurs des transistors de l'une des séries de transistors T1n ou T2n de telle sorte que $Rn. \frac{In}{2} = Vd$.

**2.** Circuit intégré de conversion numérique-analogique N/A selon la revendication 1, caractérisé en ce que, dans le cas d'une technologie bipolaire rapide à isolement par diffusion, la valeur de Vd est comprise entre sensiblement 10 mV et sensiblement 70 mV.

**Claims**

**1.** An integrated digital-to-analog (D/A) converter circuit which is provided with a device for reducing glitches and which converts control signals having n binary states Bn into analog signals, which circuit comprises n differential pairs Pn of transistors T1n and T2n connected to n current generators which supply currents having values in weighted according to the binary weights $2^n$ of the binary states Bn, the transistors T1n receiving their respective binary control signals while the transistors T2n receive the inverted versions of said binary control signals, characterized in that the instant of triggering of the differential pairs on a leading edge of the control signal is shifted with respect to the instant of triggering on a trailing edge of the control signal in that the triggering thresholds of the transistors T1n are shifted with respect to the transistors T2n by a constant value Vd produced by the device for reducing glitches which is constituted by resistors Rn connected in series with respective emitters of the transistors of one of the series of transistors T1n or T2n in such a manner that

$$Rn. \frac{In}{2} = Vd.$$

**2.** An integrated digital-to-analog (D/A) converter circuit as claimed in Claim 1, characterized in that in the case of a fast bipolar isolation diffusion technology, Vd is valued between approximately 10 mV and approximately 70 mV.

**Patentansprüche**

**1.** Integrierte Digital/Analog-Wandlerschaltung mit einer Störspitzen-Reduzierungseinrichtung, wobei die Schaltung Steuersignale mit n binären Stellen Bn in Analogsignale umsetzt, n Differenzpaare Pn aus Transistoren T1n und T2n enthält, die mit n Stromerzeugern verbunden sind, die Ströme mit Frequenzbewertungen In entsprechend der Wertigkeit $2^n$ der binären Stellen Bn liefern, wobei die Transistoren T1n mit ihren jeweiligen binären Steuersignalen und die Transistoren T2n jeweils mit den in bezug auf die vorgenannten Steuersignale invertierten binären Steuersignalen verbunden sind, dadurch gekennzeichnet, daß der Zeitpunkt des Gleichgewichts der Differenzpaare auf einer Vorderflanke des Steuersignals gegen den Zeitpunkt des Gleichgewichts auf einer Rückflanke des Steuersignals versetzt ist, wodurch eine Versetzung der Gleichgewichtsschwelle der Transistoren T1n in bezug auf die Transistoren T2n mit einem Versetzungs-Konstantwert Vd verwirklicht wird, den die Störspitzen-Reduzierungseinrichtung ausgibt, die aus Widerständen Rn besteht, die mit je einem Emitter der Transistoren einer der Transistorreihen T1n oder T2n derart in Reihe geschaltet sind, daß

$$R_n. \frac{In}{2} = Vd$$

ist.

**2.** Integrierte Digital/Analog-Wandlerschaltung nach Anspruch 1, dadurch gekennzeichnet, daß bei einer schnellen Zweipoltechnologie mit Streuungsisolierung der Vd-Wert zwischen im wesentlichen 10 mV und im wesentlichen 70 mV liegt.

6

FIG.1

FIG.2

FIG.3

FIG.4

FIG.5